# EUROPÄISCHE PATENTANMELDUNG

(11) **EP 3 739 732 A1**
(43) Veröffentlichungstag der Anmeldung: **18.11.2020**
(21) Anmeldenummer: 19175186.6
(22) Anmeldetag: 17.05.2019
(51) Int. Cl.: H02K 11/20, H02K 11/25, H02P 29/60, G05B 23/02, G01R 31/34, F03D 17/00

(54) **DYNAMOELEKTRISCHE MASCHINE MIT EINEM SPEKTRALEN ÜBERWACHUNGSSYSTEM**

(71) Anmelder: Siemens Aktiengesellschaft, 80333 München (DE)
(72) Erfinder: Weiß, Sebastian, 90522 Oberasbach (DE)

(57) **Zusammenfassung**

Die Erfindung betrifft eine dynamoelektrische rotatorische Maschine (3), insbesondere einer Nennleistung größer 300kW, mit:
- einem Gehäuse (1),
- einem Stator (4) in dem Gehäuse (1), der ein Wicklungssystem (6) aufweist, das in zu einem Luftspalt weisenden Nuten angeordnet ist und an den Stirnseiten Wickelköpfe ausbildet,
- einem Rotor (5), der über den Luftspalt hinweg mit dem Stator (4) elektromagnetisch wechselwirkt,
- einer Welle (18), die mit dem Rotor (5) drehfest verbunden ist und in Lagern (9) gehalten ist, die sich am Gehäuse (1) abstützen,
- einem Überwachungssystem, das auf das Innere des Gehäuses (1) gerichtet ist, und am oder innerhalb des Gehäuses (1) der dynamoelektrischen rotatorischen Maschine (3) angeordnet ist und unterschiedliche Spektralbereiche der elektromagnetischen Strahlung erfasst.

## Beschreibung

Um Aussagen über vorbeugende Servicemaßnahmen, Stillstand oder gar Ausfall von dynamoelektrischen Maschinen zu erhalten, werden diese mit Temperatursensoren versehen, um beispielsweise Wicklungs- und Lagertemperaturen zu erfassen oder mit Schwingungssensoren versehen, um Wellenschwingungen zu erfassen. Die Veränderung dieser erfassten Werte wird im Laufe der Betriebszeit der dynamoelektrischen Maschine beobachtet. So können lediglich Trends ermittelt werden, welche die Zeit zu abschaltrelevanten Grenzwerten aufzeigen. Ausfälle, deren Ursache ungeplante oder zufällige Fehler im Innern der Maschine sind, lassen sich so nur indirekt und insofern meist zu spät detektieren.

Ausgehend davon liegt der Erfindung die Aufgabe zugrunde, eine dynamoelektrische rotatorische Maschine zu überwachen, insbesondere das Eindringen und Ansammeln von schädlichen Stoffen wie Staub, Öl oder Wasser als auch von Wickelkopfschwingungen oder Rotorexzentrizität und thermographischen Messungen aufzuzeichnen, die nicht von Trendanalysen abhängig sind.

Die Lösung der gestellten Aufgabe gelingt durch eine dynamoelektrische rotatorische Maschine, insbesondere einer Nennleistung größer 300kW, mit:
- einem Gehäuse,
- einem Stator in dem Gehäuse, der ein Wicklungssystem aufweist, das in zu einem Luftspalt weisenden Nuten angeordnet ist und an den Stirnseiten Wickelköpfe ausbildet,
- einem Rotor, der über den Luftspalt hinweg mit dem Stator elektromagnetisch wechselwirkt,
- einer Welle, die mit dem Rotor drehfest verbunden ist und in Lagern gehalten ist, die sich am Gehäuse abstützen,
- einem Überwachungssystem, das auf das Innere des Gehäuses gerichtet ist, und am oder innerhalb des Gehäuses der dynamoelektrischen rotatorischen Maschine angeordnet ist und unterschiedliche Spektralbereiche der elektromagnetischen Strahlung erfasst.

Die dynamoelektrische Maschine kann dabei als Generator oder Motor ausgeführt sein, bzw. betrieben werden.

Die Lösung der gestellten Aufgabe gelingt auch durch ein Verfahren zur Überwachung einer dynamoelektrischen rotatorischen Maschine mittels eines Überwachungssystems innerhalb eines Gehäuses der dynamoelektrischen rotatorischen Maschine durch folgende Schritte:
- von dem oder den spektralen Überwachungssystemen werden Daten in vorgegebenen Abtast- und Zeitraten an ein übergeordnetes Datennetzwerk übermittelt, das über eine Erkennungssoftware den Zustand im Inneren des Gehäuses der dynamoelektrischen Maschine aufnimmt und verifiziert, indem
- bei Überschreiten vorgegebener Schwellwerte im Vergleich zu einem vorgegebenen Urzustand das Datenmaterial vor Ort oder über ein Cloudnetzwerk in einer vorgebbaren Art und Weise mittels Algorithmen weiterverarbeitet wird und daraus insbesondere weitere Maßnahmen wie Wartungsintervalle von Komponenten der dynamoelektrischen rotatorischen Maschine festgesetzt werden.

Durch eine elektromagnetische Wechselwirkung zwischen einem bestromten Stator und einem Rotor wird eine Rotation der dynamoelektrischen Maschine bewirkt, so dass in diesem Fall die dynamoelektrische Maschine als Motor arbeitet.

Im generatorischen Betrieb der dynamoelektrischen Maschine wird durch Rotation des Rotors im Stator eine Stromfluss generiert.

Erfindungsgemäß wird nunmehr durch die spektrale Überwachung des Innenraums der dynamoelektrischen rotatorischen Maschine mittels einer oder mehrerer vorzugsweise Digitalkameras besonders relevante oder auch alle Maschinenteile wie Lager, Wickelkopf, Welle usw. überwacht.

Unter spektraler Überwachung wird dabei das gesamte elektromagnetische Spektrum der Strahlung verstanden. Dies sind sowohl die optischen Bereiche zwischen 380nm und 780nm, als auch der Infrarot- und Ultraviolettbereich und Röntgenbereich. Ebenso werden die Mikro- und Funkwellen erfasst, die sich u.a. aufgrund von Teilentladungen im Wicklungssystem einstellen können.

Es werden damit ebenso vor allem im optischen Bereich Anlagerungen und Ansammlungen von schädlichen Stoffen, wie Staub, Öl oder Wasser, insbesondere bei offenen Maschinen, die mit Luft gekühlt werden, vor ev. Schadensausfällen zeitig erkannt.

Bei hochdynamischen Vorgängen ist es sinnvoll, die Digitalkameras als Hochgeschwindigkeitskameras mit sehr geringen Abtastraten auszuführen, um auch Schwingungen von Bauteilen im Inneren des Gehäuses der dynamoelektrischen Maschine zu erfassen. Diese Schwingungen betreffen den Wickelkopf als auch die Welle oder den Rotor. Insbesondere beim Wickelkopf besteht die Gefahr, dass die Isolationen im Wickelkopfbereich durch Schwingungen beschädigt wird und somit Teilentladungen oder gar Überschläge auftreten.

Vorteilhafterweise ist die Kamera oder sind die Kameras einer dynamoelektrischen rotatorischen Maschine in ein Datennetzwerk eingebunden, über das die erfassten Daten, insbesondere Bilder versendet, gespeichert, nach vorgebbaren Algorithmen ausgewertet werden und ggf. Maßnahmen abgeleitet werden.

Vorteilhafterweise ist der Auswertung der erfassten Daten eine Erkennungssoftware, insbesondere Bilderkennungssoftware hinterlegt, die automatisch den Zustand, insbesondere optischen Zustand im Inneren der Maschine überwacht. Bei Änderungen oder bei Überschreiten vorgegebener Schwellwerte im Vergleich zum Auslieferungszustand der Maschine bzw. Urzustand der Maschine wird das bisher gesammelte Datenmaterial, insbesondere Bildmaterial entweder von einem zuständigen Servicetechniker und/oder einer entsprechende KI (künstlichen Intelligenz) anhand von vorgegebenen Algorithmen beurteilt oder zumindest einem vorgebbaren Zustand zugewiesen, der weitere Maßnahmen ermöglicht.

Diese in einer oder mehreren Maschinen aufgenommenen Daten werden in einer weiteren Ausführung einem System zur Verfügung gestellt, das eine Plattform zum Bereitstellen einer Vielzahl von Diensten, wobei die Dienste Asset-Onboarding, Datenspeicherung, Datenanalyse und Datenvisualisierung umfasst; wobei die Plattform in einem verteilten Computernetzwerk (Cloud Computersystem) ausführbar ist, wobei ein oder mehrere Dienste über eine in dem verteilten Computernetzwerk ausgeführte Anwendung zugänglich sind, wobei die Anwendungen für Benutzervorrichtungen zugänglich sind, die über die Plattform mit dem verteilten Computernetzwerk verbunden sind.

Aufgrund der aufgenommenen Daten sind daraufhin Servicemaßnahmen sofort an der Maschine einleitbar oder die Maschine stillgelegt bevor irreparable Schäden an Maschine und/oder Personal auftreten.

Die Kameras werden insbesondere auf ihre Eignung als Hochgeschwindigkeitskameras, Infratorkameras dementsprechend an und/oder im Inneren des Gehäuses angeordnet, je nach Aufgabenstellung ob sie nur Temperaturen, Schwingungen oder hochfrequente Vorgänge aufnehmen sollen.

Die Erfindung sowie weitere vorteilhafte Ausgestaltungen der Erfindung werden anhand der folgenden Ausführungsbeispiele näher erläutert. Darin zeigen:
- FIG 1 und FIG 2: Längsschnitte einer dynamoelektrischen Maschine,
- FIG 3: Querschnitt einer dynamoelektrischen Maschine,
- FIG 4: eine weitere elektrische Maschine.

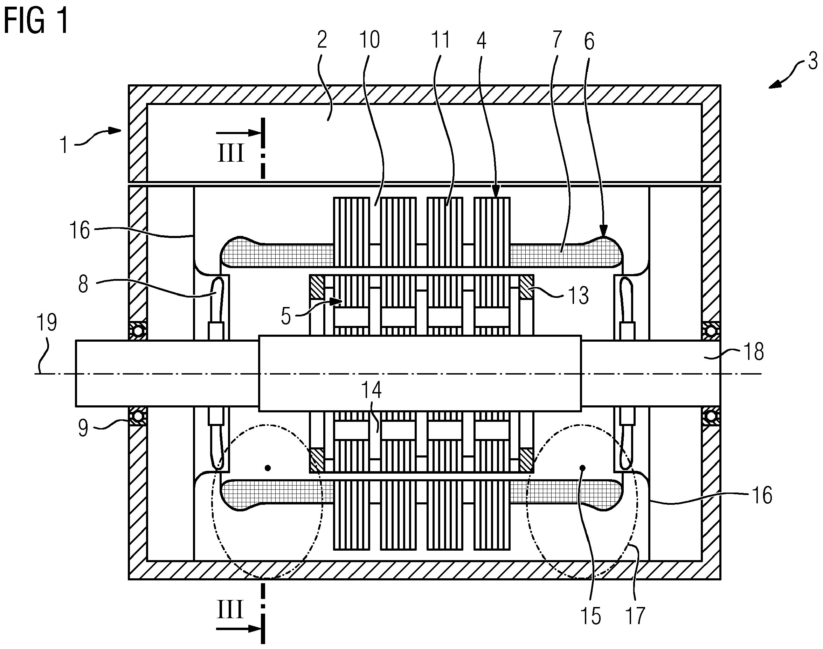

FIG 1 zeigt eine dynamoelektrische Maschine 3 in einem Gehäuse 1, das einen Aufsatzkühler 2 aufweist und dass aufgrund der Anordnung der Wellenlüfter 8 eine zweiseitige Belüftung aufweist. Die Belüftung wird durch die Wellenlüfter 8, die Anordnung von Leitelementen zur Führung eines Luftstroms und durch die radialen Kühlkanäle 10 in einem Stator 4 oder radiale Kühlkanäle 14 im Rotor 5 gewährleistet. Die dynamoelektrische Maschine 3 weist einen geschlossenen Innenkühlkreislauf auf, der durch den Aufsatzkühler 2 rückgekühlt wird. Im Stator 4 ist ein Wicklungssystem 6 in nicht näher dargestellten Nuten angeordnet, wobei das Wicklungssystem 6 an den Stirnseiten des Stators 4 Wickelköpfe 7 ausbildet. Der Rotor 5 weist an seinen Stirnseiten, da es sich im vorliegenden Fall um einen Käfigläufer handelt, Kurzschlussringe 13 auf.

In einer derartigen Maschine 3 wird aufgrund der umgewälzten Luftmenge Teilchen wie Staub, Öl aus den Lagern 9 oder Kondenswasser mit umgewälzt. Im Betrieb der dynamoelektrischen Maschine 3 treten je nach Betriebszustand, Aufstellungsort etc. Schwingungen von Wickelköpfen 7 und/oder Rotorexzentrizitäten auf. Diese Erscheinungen werden mittels der spektralen, insbesondere optischen Erfassung an den oben beschriebenen Bauteilen, wie Kurzschlussring 13 oder Wickelkopf 7 aufgenommen.

Eine weitere Möglichkeit Schwingungen zu erfassen besteht darin mittels eines Lasers schwingungsfähige Komponenten der dynamoelektrischen Maschine 3, wie Welle, Wickelkopf 7, Rotor 5 etc. anzustrahlen und aufgrund der von Sensoren und/oder einer Kamera aufgenommenen reflektierten Strahlung letztendlich Schwingungen festzustellen.

Unter spektraler Überwachung wird dabei das gesamte elektromagnetische Spektrum der Strahlung verstanden. Dies sind sowohl die optischen Bereiche zwischen 380nm und 780nm, als auch der Infrarot- und Ultraviolettbereich und Röntgenbereich. Ebenso werden die Mikro- und Funkwellen erfasst, die sich u.a. aufgrund von Teilentladungen im Wicklungssystem einstellen können.

Diese optische Erfassung erfolgt erfindungsgemäß mittels einer oder mehrerer Digitalkameras im elektromagnetischen Spektrum, also zumindest von infrarot bis ultraviolett.

Um ein kostengünstiges Überwachungssystem aufzubauen, können auch Massenprodukte, wie Webcams in oder an der dynamoelektrischen Maschine 3 installiert werden. Für speziellere Anforderungen werden jedoch Infrarotkameras zur Überwachung der Temperaturen und/oder Hochgeschwindigkeitskameras zur Erfassung von Schwingungen beispielsweise am Wickelkopf oder am Rotor 5 verwendet. D.h., eine derartige dynamoelektrische Maschine 3 verwendet je nach Einsatzort, um ein komplettes System zu überwachen, unterschiedliche empfindliche Digitalkameras, so dass deren Überwachungsbereiche 17 sich auch überlappen können. D.h., es werden durch die eine Kamera im Beobachtungsbereich 17 Temperaturen erfasst, ebenso wie durch eine andere Kamera in diesem Beobachtungsbereich 17 Schwingungen erfasst werden. Jedoch mit unterschiedlichen Abtastraten, Empfindlichkeiten etc.

Vorteilhafterweise können diese Daten der dynamoelektrischen Maschine 3 in ein Datennetzwerk eingebunden sein und liegen somit u.a. einer Warte zur weiteren Auswertung und Validierung. Damit lassen sich Servicemaßnahmen an einer dynamoelektrischen Maschine 3 vor Ort vorzeitig einleiten, bevor die dynamoelektrische Maschine 3 ausfällt oder sich irreparable Schäden einstellen.

In der vorliegenden Asynchronmaschine werden, um auch dementsprechend optische Signale erfassen zu können, Lichtquellen innerhalb der Seitenwände der dynamoelektrischen Maschine angeordnet, um einen optischen Überwachungsvorgang also auch im sichtbaren Bereich stattfinden zu lassen.

In einer weiteren Ausführungsform lassen sich die Kameras 15 in ihrem Beobachtungsbereich 17 über die Warte, vor Ort oder auch über ein Datennetzwerk verschwenken bzw. gewisse Bauteile näher zoomen.

Damit lassen sich beispielsweise auf den Wickelköpfen 7 die konkret nach Ablagerung oder Rissen suchen, welche die Spannungsfestigkeit der Wicklung 6 beeinträchtigen können.

Ebenso kann auch der Boden bezüglich des Eindringens schädlicher Mengen von Flüssigkeiten überwacht werden.

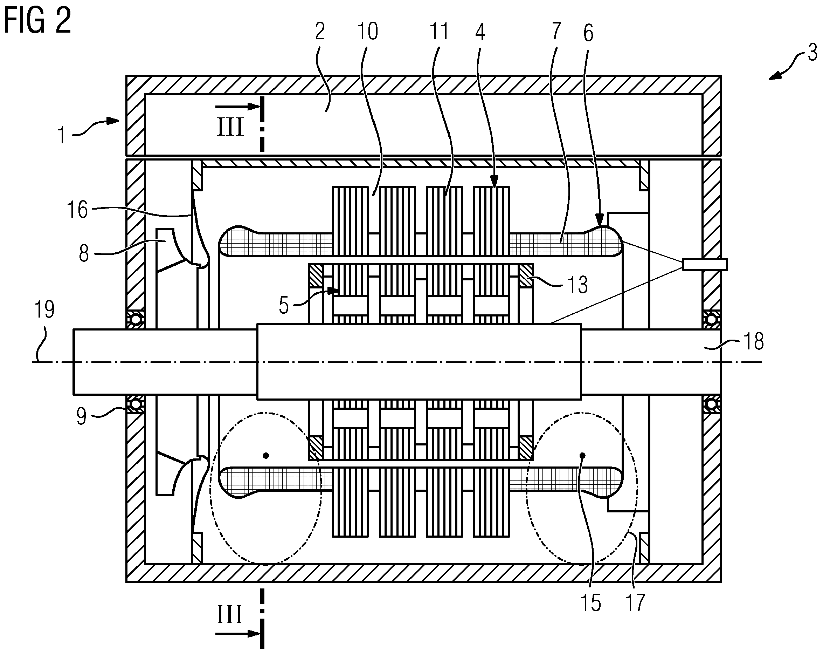

FIG 2 zeigt eine Asynchronmaschine die ähnlich aufgebaut ist wie die dynamoelektrische Maschine 3 gemäß FIG 1, jedoch mit nur einer einseitigen Belüftung.

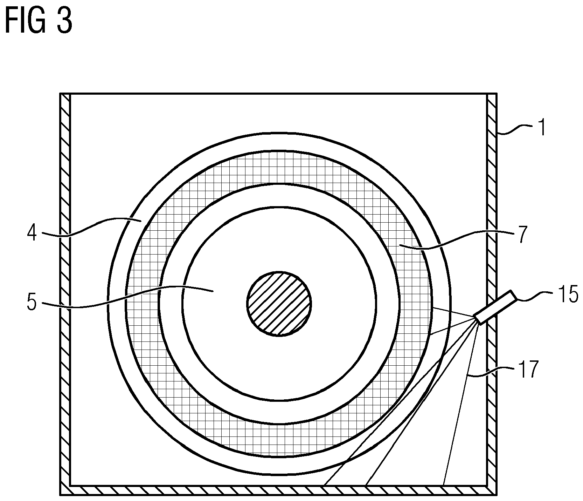

FIG 3 zeigt den Schnitt einer dynamoelektrischen Maschine 3 nach FIG 1 oder 2, die den Beobachtungsbereich 17 einer Kamera 15 näher spezifiziert.

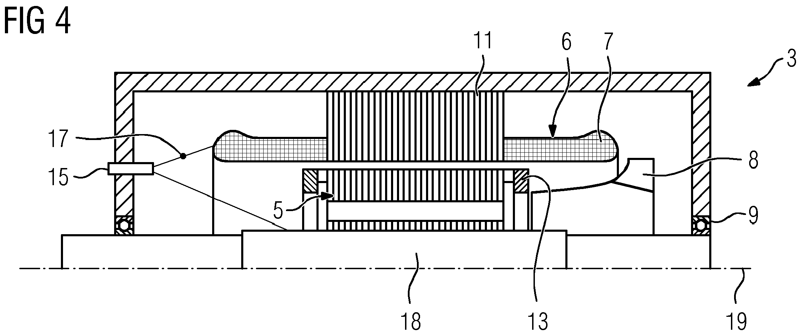

Eine weitere dynamoelektrische Maschine 3 nach FIG 4 zeigt die Anordnung einer Kamera 15 auf der Seite des Abtriebswellenendes zur Überwachung der Rotor- und Wickelkopfstirnseite.

Die Kameras 15 werden normalerweise derartig innerhalb einer Seitenwand des Gehäuses 1 platziert, dass sie zugänglich sind, austauschbar sind oder gegebenenfalls die spektralen Sensoren, also die Linsen der Kameras 15 gesäubert werden können.

Eine derartige erfindungsgemäße dynamoelektrische Maschine wird vorzuweise im industriellen Umfeld bei Hochspannungsmaschinen oder Windkraftgeneratoren von On- und Offshore Windkraftanlagen eingesetzt.

## Patentansprüche

1. Dynamoelektrische rotatorische Maschine (3), insbesondere einer Nennleistung größer 300kW, mit:
- einem Gehäuse (1),
- einem Stator (4) in dem Gehäuse (1), der ein Wicklungssystem (6) aufweist, das in zu einem Luftspalt weisenden Nuten angeordnet ist und an den Stirnseiten Wickelköpfe ausbildet,
- einem Rotor (5), der über den Luftspalt hinweg mit dem Stator (4) elektromagnetisch wechselwirkt,
- einer Welle (18), die mit dem Rotor (5) drehfest verbunden ist und in Lagern (9) gehalten ist, die sich am Gehäuse (1) abstützen,
- einem Überwachungssystem, das auf das Innere des Gehäuses (1) gerichtet ist, und am oder innerhalb des Gehäuses (1) der dynamoelektrischen rotatorischen Maschine (3) angeordnet ist und unterschiedliche Spektralbereiche der elektromagnetischen Strahlung erfasst.

2. Dynamoelektrische rotatorische Maschine (3) nach Anspruch 1, **dadurch gekennzeichnet, dass** die dynamoelektrische rotatorische Maschine (3) ein Überwachungssystem aufweist, das optische oder infrarote oder andere elektromagnetische Strahlung erfasst.

3. Dynamoelektrische rotatorische Maschine (3) nach Anspruch 1 oder 2, **dadurch gekennzeichnet, dass** das Überwachungssystem, zumindest eine Kamera (15) mit unterschiedlichen einstellbaren Auflösungen, Zoombereichen und zeitlichen Abtastraten aufweist.

4. Verfahren zur Überwachung einer dynamoelektrischen rotatorischen Maschine (3) mittels eines Überwachungssystems innerhalb eines Gehäuses (1) der dynamoelektrischen rotatorischen Maschine (3) durch folgende Schritte:
- von dem oder den spektralen Überwachungssystemen werden Daten in vorgegebenen Abtast- und Zeitraten an ein übergeordnetes Datennetzwerk übermittelt, das über eine Erkennungssoftware den Zustand im Inneren des Gehäuses (1) der dynamoelektrischen Maschine (3) aufnimmt und verifiziert, indem
- bei Überschreiten vorgegebener Schwellwerte im Vergleich zu einem vorgegebenen Urzustand das Datenmaterial vor Ort oder über ein Cloudnetzwerk in einer vorgebbaren Art und Weise mittels Algorithmen weiterverarbeitet wird und

5. Verfahren zur Überwachung einer dynamoelektrischen rotatorischen Maschine (3) nach Anspruch 4, **dadurch gekennzeichnet, dass** aus diesem weiterverarbeiteten Datenmaterial, weitere Maßnahmen wie Wartungsintervalle von Komponenten der dynamoelektrischen rotatorischen Maschine (3) festgesetzt bzw. abgeleitet werden.

6. Verfahren zur Überwachung einer dynamoelektrischen rotatorischen Maschine (3) nach Anspruch 4 oder 5, **dadurch gekennzeichnet, dass** das Überwachungssystem Mittel aufweist um unterschiedliche Spektralbereiche der elektromagnetischen Strahlung zu erfassen.

7. Verfahren zur Überwachung einer dynamoelektrischen rotatorischen Maschine (3) nach einem der Ansprüche 4 bis 6, **dadurch gekennzeichnet, dass** das Überwachungssystem Kameras (15) aufweist, die vorzugsweise den optischen Spektralbereich erfassen.

8. Windkraftanlage mit einer dynamoelektrischen rotatorischen Maschine (3) nach einem der Ansprüche 1 bis 3.
